# EUROPÄISCHE PATENTSCHRIFT

(11) **EP 1 977 486 B1**
(45) Veröffentlichungstag und Bekanntmachung des Hinweises auf die Patenterteilung: **19.03.2014**
(21) Anmeldenummer: 07702350.5
(22) Anmeldetag: 16.01.2007
(51) Int. Cl.: H01S 5/022, H01S 5/40, H01S 5/024

(54) **TRÄGER FÜR EINE VERTIKALE ANORDNUNG VON LASERDIODEN MIT ANSCHLAG**
CARRIER FOR A VERTICAL ARRANGEMENT OF LASER DIODES WITH A STOP
SUPPORT POUR UN DISPOSITIF VERTICAL DE DIODES LASER AVEC BUTÉE

(30) Priorität: 18.01.2006 DE 102006002876
(43) Veröffentlichungstag der Anmeldung: 08.10.2008
(73) Patentinhaber: JENOPTIK Laser GmbH, 07745 Jena (DE)
(72) Erfinder: LORENZEN, Dirk, 07745 Jena (DE); HENNIG, Petra, 07646 Mörsdorf (DE); SCHRÖDER, Matthias, 07646 Stadtroda (DE); RÖLLIG, Ulrich, 07743 Jena (DE)
(74) Vertreter: Waldauf, Alexander
(86) Internationale Anmeldenummer: PCT/DE2007/000069
(87) Internationale Veröffentlichungsnummer: WO 2007/082508

(56) Entgegenhaltungen:
- DE-A1- 10 229 712
- US-A- 5 985 684
- US-A- 5 999 269
- US-A1- 2004 082 112
- US-B1- 6 266 353
- US-B1- 6 424 667
- ENDRIZ J G ET AL: "HIGH POWER DIODE LASER ARRAYS" IEEE JOURNAL OF QUANTUM ELECTRONICS, IEEE SERVICE CENTER, PISCATAWAY, NJ, US, Bd. 28, Nr. 4, 1. April 1992 (1992-04-01), Seiten 952-965, XP000272686 ISSN: 0018-9197
- WEISS S ET AL: "Design, simulation and technological realization of a reliable packaging concept for high power laser bars" ELECTRONIC COMPONENTS & TECHNOLOGY CONFERENCE, 1998. 48TH IEEE SEATTLE, WA, USA 25-28 MAY 1998, NEW YORK, NY, USA,IEEE, US, 25. Mai 1998 (1998-05-25), Seiten 1395-1401, XP010283870 ISBN: 0-7803-4526-6
- LORENZEN D; HENNIG P: "Highly thermally conductive substrates with adjustable CTE for diode laser bar packaging" PROCEEDINGS OF THE SPIE - THE INTERNATIONAL SOCIETY FOR OPTICAL ENGINEERING, Bd. 4945, 28. Oktober 2002 (2002-10-28), Seiten 174-185, XP009081286

## Beschreibung

Die Erfindung bezieht sich auf eine Laserstrahlungsquelle, die einen vertikalen Stapel von Laserdiodenelementen aufweist.

Zum Pumpen von Festkörperlasern, für die industrielle Laser-Materialbearbeitung und auch in der Medizintechnik werden üblicherweise Hochleistungsdiodenlaser in Form von Laserdiodenbarren verwendet, die durch Stapeln zu zweidimensional emittierenden Flächen mit einer erhöhten Strahlungsleistung aufgebaut werden können.

Von zahlreichen Vorschlägen für so genannte Stacks, beschreibt die US 5 923 692 A ein Hochleistungsdiodenlaserarray aus vertikal gestapelten und über elektrisch leitende Substratschichten kontaktierte Laserdiodenbarren. Über eine der Substratschichten besteht ein thermischer Kontakt zu einer thermisch leitfähigen und elektrisch isolierenden Tragerplatte, die mit einer Wärmesenke verbunden ist. Die Laserdiodenbarren sind in Serie geschaltet, indem die elektrisch leitenden Substratschichten benachbarter Laserdiodenbarren direkt miteinander verbunden sind.

Das hat einerseits den Nachteil, dass thermo-mechanische Spannungen auftreten können, da die Laserdiodenbarren sowohl untereinander als auch mit der Tragerplatte verbunden sind.
Andererseits führen Dickenschwankungen bei den Laserdiodenbarren und den elektrisch leitenden Substratschichten zu Abstandsschwankungen zwischen den Laserdiodenbarren

Eine ähnliche Laserstrahlungsquelle ist in US 2004/0082112 dargestellt. Bei dieser Strahlungsquelle erfolgt die elektrische Isolation mittels Isolationselementen, die jeweils zwischen den Substratschichten und dem Trager angeordnet sind. Hier sind die gleichen Nachteile wie beim vorgenannten Stack zu erwarten

US 5 985 684 offenbart eine Laserstrahlungsquelle mit einem Stapel von Laserdiodenelementen, die einen mehrschichtigen Träger enthält. Dabei sind Laserdiodenbarren auf jeweils einer Substratschicht aufgebracht. Auf der gegenüberliegenden Kontaktseite der Laserbarren sind metallische Deckelbleche vorhanden. Die Laserdiodenelemente sind derart auf den Träger aufgebracht, daß die Substratschichten mit dem Träger verbunden sind, während die Deckel mit der jeweils benachbarten Substratschicht elektrisch und mechanisch flächig verbunden sind Über die genannte Verbindung wird der Stromfluß geführt.
Das hat einerseits den Nachteil, dass mechanische und thermo-mechanische Spannungen auftreten können.
Andererseits führen Dickentoleranzen bei den Laserdiodenbarren, den elektrisch leitenden Substratschichten und den Deckelblechen zu Abstandstoleranzen zwischen den Laserdiodenbarren, die sich zudem noch in Stapelrichtung aufsummieren.
Eine ähnliche Laserstrahlungsquelle, welche die gleichen Nachteile aufweist, ist auch in US 6 424 667 dargestellt.

US 6 266 353 B1 offenbart eine Laserstrahlungsquelle mit einem strukturierten Träger, der als voluminöses Bauteil ausgebildet ist. In diesem Träger sind Nuten zur Aufnahme von Laserdiodenbarren vorhanden. Das hat mehrere Nachteile. Die Herstellung des Trägers, insbesondere die Einarbeitung der Nuten ist aufwändig und nur mit begrenzter Genauigkeit möglich. Zur Stromführung ist eine strukturierte Metallisierung in mehreren Ebenen erforderlich Die Herstellung der metallisierten Bereiche auf dem Träger ist aufwändig und es ist schwierig, die zur Montage von Laserdiodenbarren erforderliche Ebenheit zu erreichen.

DE 102 29 712 beschreibt ein Halbleitermodul mit einem Träger, welcher als Mikrokanalkühler ausgebildet ist.

Es ist deshalb Aufgabe der Erfindung, eine in der Leistung skalierbare Laserstrahlungsquelle derart zu gestalten, dass Laserdiodenelemente mit geringem Fertigungsaufwand äquidistant gestapelt und spannungsarm auf einen Träger aufgebracht werden können.

Erfindungsgemäß wird die Aufgabe durch eine Laserstrahlungsquelle gelöst, die
- einen Stapel von Laserdiodenelementen, die beidseitig über Substratschichten aus elektrisch leitendem Material kontaktiert sind und
- wenigstens einen ersten ebenen, mehrschichtigen plattenförmigen Träger enthält, der aus einer ersten und wenigstens einer zweiten metallischen Schicht besteht, die durch mindestens eine elektrisch isolierende Schicht aus nichtmetallischem Material getrennt sind, wobei
- wenigstens die erste metallische Schicht in nebeneinander und mit einem Abstand zueinander angeordnete metallische Schichtenbereiche gegliedert ist, und wobei
- gegenpolige Substratschichten benachbarter Laserdiodenelemente auf gemeinsamen Schichtenbereichen einer metallischen Schicht aufgebracht sind.

Gemäß der Erfindung steht jedes Laserdiodenelement über die p- und n-seitigen Substratschichten mit den elektrisch leitenden Schichtenbereichen im elektrischen und somit mit dem Träger im thermischen Kontakt Aufgrund der Nutzung gemeinsamer Schichtenbereiche für gegenpolige Substratschichten benachbarter Laserdiodenelemente wird der Stromfluss bei der Serienschaltung über die metallischen Schichtenbereiche des Trägers geführt.

Besonders vorteilhaft kann deshalb zwischen den gegenpoligen Substratschichten benachbarter Laserdiodenelemente ein Spalt freigelassen werden, wodurch sich die Laserdiodenelemente hochgenau äquidistant positionieren lassen, indem auf einfache Weise ein Ausgleich von Dickentoleranzen bei den Laserdiodenelementen und den Substratschichten vorgenommen werden kann.

Da die sandwichartig aufgebauten Komponenten aus Laserdiodenelementen und Substratschichten einzeln und unabhängig voneinander auf den Träger aufgebracht werden können, lässt sich ein spannungsarmer Aufbau gestalten.

Zur Herstellung des Trägers besonders geeignet ist die DCB-Technologie, da ein derartig gefertigter Aufbau einerseits eine gute Wärmeleitfähigkeit gewährleistet, andererseits aber auch durch ausreichende Schichtdicken der aus Kupfer bestehenden Oberflächenschichten den Durchfluss von einigen Hundert Ampere zulässt.

Weitere Vorteile bestehen dann, dass mit der Erfindung eine leichte und wenige Komponenten aufweisende Laserstrahlungsquelle bereitgestellt werden kann, die keine Verschraubungen und lösbaren mechanischen Teile aufweist und die frei ist von ausgasenden Materialien. Zudem lässt sich mit dem vorgeschlagenen Konzept eine einfache Skalierung realisieren

In vorteilhafter Ausgestaltung kann der Träger mit einem zwischen nichtmetallischen Schichten angeordneten Mikrokühler ausgestattet sein, der Kanäle für ein Kühlmedium aufweist, für das ein Zufuhrkanal und ein Ableitungskanal im Boden des Trägers vorgesehen sind.

Die Substratschichten, die den vertikalen Stapel von Laserdiodenelementen begrenzen, sind jeweils allein auf einen Schichtenbereich aufgelötet, wobei an jeden Schichtenbereich ein elektrisches Kontaktelement zur Stromzufuhr geführt ist. Vorteilhaft wirkt sich hierbei aus, wenn die Schichtenbereiche, auf denen die den vertikalen Stapel von Laserdiodenelementen begrenzenden Substratschichten aufgelötet sind, im elektrischen Kontakt mit jeweils einem Schichtenbereich auf der gegenüberliegenden Seite des Trägers stehen, auf der die elektrischen Kontaktelemente an dem Schichtenbereich angebracht sind - zum Beispiel über eine Durchkontaktierung in der elektrisch isolierenden Schicht.

Weitere vorteilhafte Ausgestaltungen und Weiterbildungen der erfindungsgemäßen Laserstrahlungsquelle ergeben sich aus den abhängigen Ansprüchen.

Die Erfindung soll nachstehend anhand der schematischen Zeichnung naher erläutert werden. Es zeigen:
- Fig. 1: eine Draufsicht auf eine erfindungsgemäße Laserstrahlungsquelle
- Fig. 2: die Unterseite eines Trägers für einen Laserdiodenstapel gemäß der Erfindung
- Fig. 3: eine Seitenansicht der Laserstrahlungsquelle gemäß Fig. 1
- Fig. 4: einen Ausschnitt X aus Fig. 3
- Fig. 5: eine Durchkontaktierung zwischen Schichtenbereichen auf der Ober- und der Unterseite des Trägers in einen Ausschnitt Y aus Fig. 3
- Fig 6: die Positionierung von Kollimatorlinsen vor jeden Laserdiodenbarren des Laserdiodenstapels
- Fig. 7: einen als Mikrokühler ausgebildeten Träger für den Laserdiodenstapel
- Fig. 8: den Träger gemäß Fig. 7 mit aufgebrachtem Laserdiodenstapel
- Fig. 9: einen Schnitt durch eine weitere Ausführung einer erfindungsgemäßen Laserstrahlungsquelle
- Fig. 10: Abmessungsverhältnisse bei Laserdiodenelementen gemäß Fig. 9

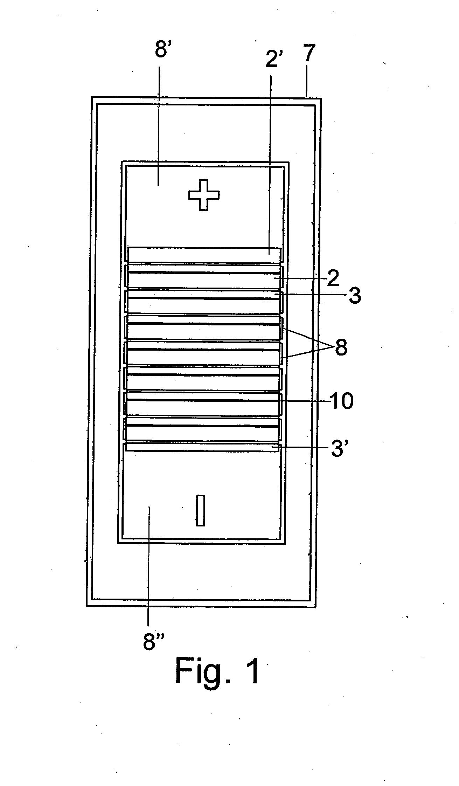

Bei der in Fig. 1 bis 6 dargestellten Laserstrahlungsquelle sind als Laserdiodenbarren 1 ausgebildete Laserdiodenelemente (z. B aus GaAs) durch Substratschichten 2, 3 aus elektrisch leitendem Material (z. B. Substratschichten mit einem ähnlichen thermischen Ausdehnungskoeffizienten wie das Material des Laserdiodenbarrens wie Kupfer-Wolfram) p- und n-seitig mittels Weichlot (z. B. eutektisches Gold-Zinn Au80Sn20) verbunden und damit kontaktiert und auf einen zur Stromzufuhr und zur Wärmeabfuhr dienenden Träger 4 aufgebracht.

Die Dicke der Substratschichten 2, 3, d h. deren Abmessung in Stapelrichtung der Laserdiodenbarren 1 ist vergleichbar mit der Resonatorlänge der Laserdiodenbarren 1. In bevorzugten Ausführungen sollte die Dicke der p-seitigen Substratschichten 2 das 0,5-bis 1-fache und die der n-seitigen Substratschichten 3 das 0,25- bis 0,5-fache der Resonatorlänge der Laserdiodenbarren 1 betragen Durch unterschiedliche Dicken der n-seitigen Substratschichten 3 kann eine Abstandsanderung (Pitch) zwischen den Laserdiodenbarren 1 vorgenommen werden.

Die Länge L der Substratschichten 2, 3 über den Schrchtenbereichen 8 übersteigt die Resonatorlänge, ist jedoch aus Grunden der thermischen Weglange vorzugsweise immer kleiner als das Doppelte der Resonatorlänge.

Der als dunne Platte ausgebildete Träger 4, der bevorzugt nach dem DCB-Verfahren (direct copper bonding) hergestellt ist, weist auf der Ober- und Unterseite metallische Schichten 5, 6 aus Kupfer auf, die durch mindestens eine nichtmetallische Schicht 7 aus einer Aluminiumnitrid-Keramik getrennt sind.

Von Bedeutung ist, dass die Summe der Dicken der metallischen Schichten und die Summe der Dicken der nichtmetallischen Schichten in einem bestimmten Verhältnis stehen, um einen mittleren thermischen Ausdehnungskoeffizienten in der Montageebene zu erzielen, der näherungsweise dem der getragenen Elemente entspricht.

Im besonderen Fall des im DCB-Verfahren aufgetragenen Kupfers, das durch dieses Verfahren eine wohldefinierte Härte erhält, sollte die Summe der Dicken der metallischen Schichten doppelt so groß sein wie die Summe der Dicken der nichtmetallischen Schichten aus Aluminiumnitrid. Geeignete Kupferschichtdicken liegen in einem Bereich von 0,1 mm bis 1 mm bei dementsprechender Keramikschichtdicke und gewährleisten durch ihre Steifigkeit eine hohe Ebenheit des Trägers 4.

Bei anderen Härtegraden des Kupfers ist ein anderes Dickenverhältnis erforderlich, um einen gewünschten Ausdehnungskoeffizienten für den Träger 4 zu erhalten Fur Vickershärten des Kupfers von HV60 bis HV120 sind Dickenverhältnisse zu wählen, bei denen die Summe der Dicken der metallischen Schichten zu der Summe der Dicken der nichtmetallischen Schichten Verhältnisse von 1,5:1 bis 2,0:1 annimmt

Auf der Seite des Trägers 4, die zur Aufnahme der Laserdiodenbarren 1 vorgesehen ist, ist die metallische Schicht, hier die Schicht 5 der Oberseite, in Schichtenbereiche 8 unterteilt, die als elektrische Leitungsbahnen parallel zueinander und mit einem Abstand nebeneinander angeordnete Streifen bilden. Auf die Schichtenbereiche 8 werden die Substratschichten 2, 3 aus elektrisch leitendem Material bevorzugt mit einem Weichlot, wie z. B eutektisches Gold-Zinn Au80Sn20, aufgelötet, wodurch über beide Substratschichten 2, 3 sowohl ein elektrischer Kontakt zu den Schichtenbereichen 8 als auch ein thermischer Kontakt zu dem Träger 4 hergestellt wird

Gemäß der Erfindung werden die Substratschichten 2, 3 mit den Schichtenbereichen 8 derart verbunden, dass gegenpolige Substratschichten 2, 3 benachbarter Laserdiodenbarren 1 auf gemeinsamen Schichtenbereichen 8 aufgebracht sind.

Zwischen den gegenpoligen Substratschichten 2, 3 kann besonders vorteilhaft für eine äquidistante Abstandseinstellung zwischen den Laserdiodenbarren 1 ein Spalt 10 freigelassen werden, da der Stromfluss vom n-Kontakt eines ersten Laserdiodenbarrens 1 zum p-Kontakt eines benachbarten zweiten Laserdiodenbarrens 1 gemäß der Erfindung über den Träger 4, insbesondere über jeweils einen gemeinsamen Schichtenbereich 8 geführt ist.

Die beiden außen liegenden Substratschichten des Laserdiodenstapels, eine p-kontaktseitige Substratschicht 2' und eine n-kontaktseitige Substratschicht 3', sind jeweils allein auf einen Schichtenbereich 8' und 8" aufgelötet, wobei an jeden Schichtenbereich 8', 8" ein nicht dargestelltes elektrisches Kontaktelement zur Stromzufuhr geführt ist.

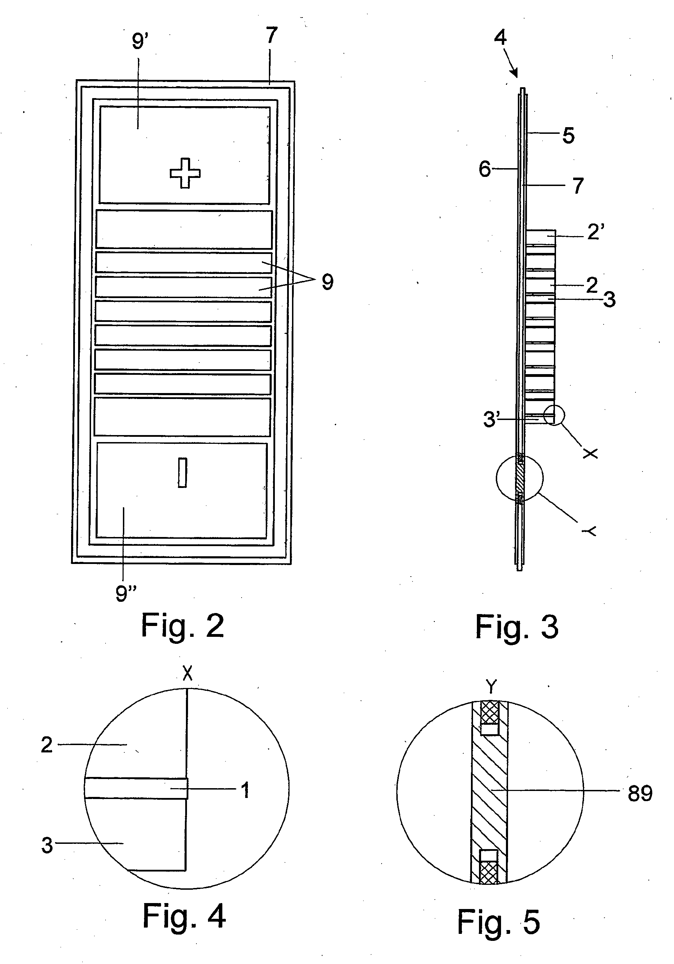

Bevorzugt erfolgt die Stromzufuhr dadurch, dass von den Schichtenbereichen 8', 8" eine elektrische Durchkontaktierung 89, dargestellt in Fig 5, durch die nichtmetallische Schicht 7 zu einem Schichtenbereich 9', 9" auf der gegenüberliegenden Seite des Trägers 4 vorhanden ist. Die Seite des Trägers 4 mit den Laserdiodenbarren 1 kann dadurch von relativ großen elektrischen Kontaktelementen, die hinderlich auf die Strahlausbreitung wirken können, freigehalten werden, wenn die elektrischen Kontaktelemente an der gegenüberliegenden Seite angebracht werden.

Um einer möglichen Verkrümmung des Trägers 4 im Fugeprozess der Schichten 5, 6 und 7 oder bei der Montage der verbundenen Elemente 1, 2 und 3 auf den Träger 4 vorzubeugen, ist bevorzugt auch die metallische Schicht 6 auf der Unterseite des Trägers 4 in Schichtenbereiche 9 unterteilt, wobei die Schichtenbereiche 9 den Schichtenbereichen 8 gegenüberliegen oder entsprechend Fig. 2 zu diesen versetzt angeordnet sein können

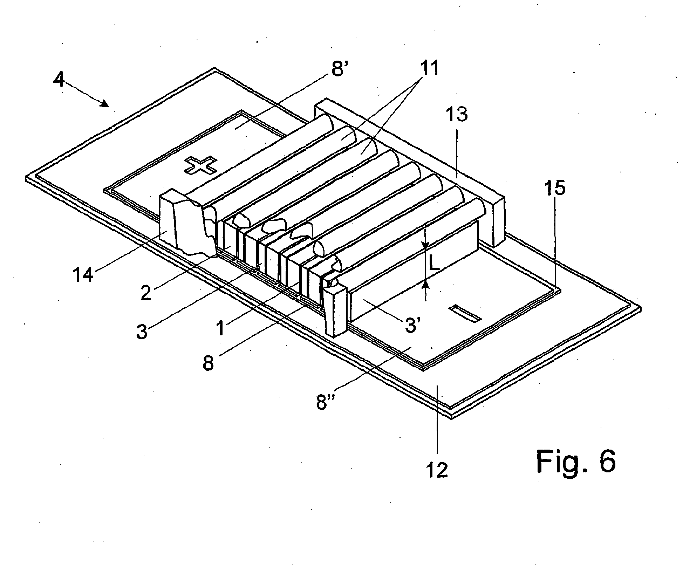

Je nach Dicke der n-seitigen Substratschichten 3 lässt sich der nötige Bauraum schaffen, um vor jeden Laserdiodenbarren 1 Kollimatorlinsen 11 gemäß Fig. 6 anordnen zu können.
Besonders vorteilhaft eignen sich seitlich zu den Laserdiodenbarren 1 positionierte und auf den Träger 4 auf einen Schichtenbereich 12 der metallischen Schicht 5 aufgelötete Brückenelemente 13, 14, an denen die Kollimatorlinsen 11 z. B. durch laserinitiierte Lötverbindungen mit niedriger schmelzenden Loten, wie z. B. zinnreiches eutektisches Zinn-Silber-Kupfer (SAC-Lot), befestigt sind.
Der Schichtenbereich 12 ist durch einen umlaufenden durchgängigen Spalt 15 elektrisch von den übrigen Schichtenbereichen 8, 8' und 8'' der metallischen Schicht der Oberseite getrennt

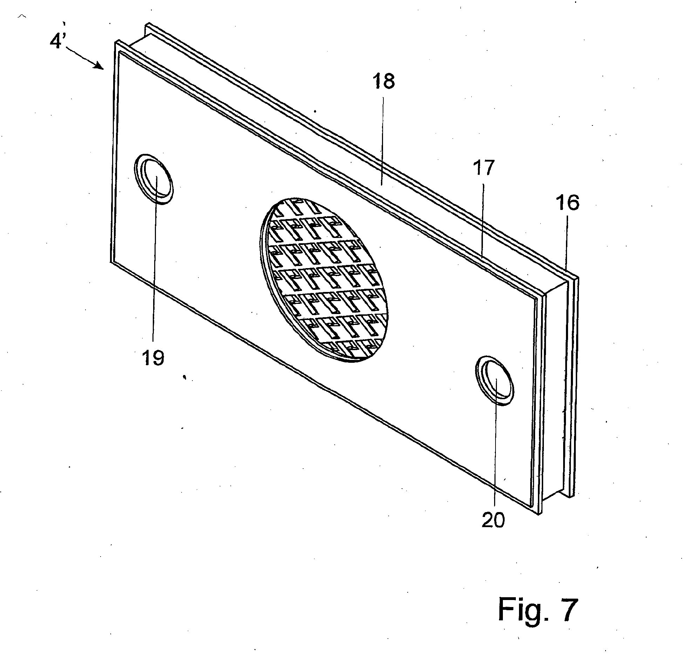

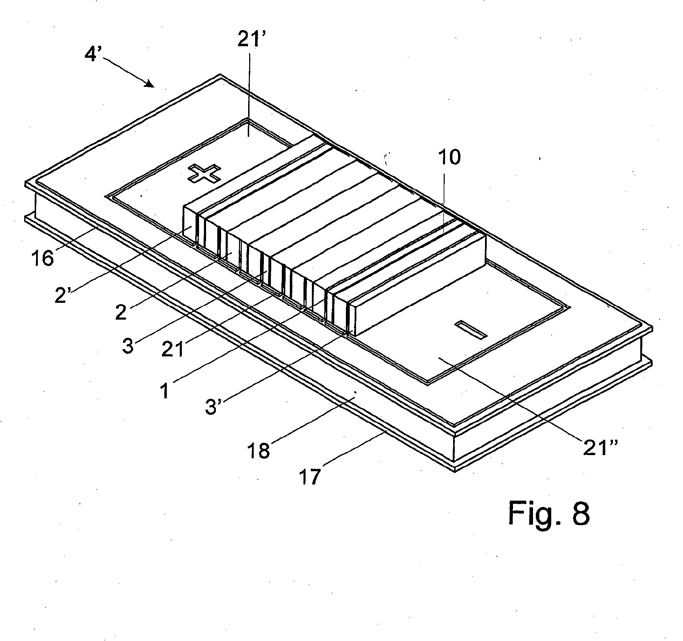

In einer weiteren Ausführung der Erfindung kann gemäß Fig. 7 und 8 anstelle des plattenförmigen Trägers 4 auch ein Träger 4' zur Anwendung kommen, der mit einem, zwischen zwei nichtmetallischen Schichten 16, 17 aus Aluminiumnitrid-Keramikschichten angeordneten Mikrokühler 18 ausgestattet ist. Der Mikrokuhler 18 wird durch mehrere strukturierte Metallschichten gebildet, die durch ihre Strukturierung dreidimensional sich verzweigende Kanäle für ein Kühlmedium bilden, für das ein Zufuhrkanal 19 und ein Ableitungskanal 20 im Boden des Trager 4' vorgesehen sind.

Analog dem Träger 4 ist auch der Träger 4' auf der Ober- und der Unterseite mit metallischen Schichten aus Kupfer beschichtet, wobei die Kupferschicht der Oberseite eine Struktunerung entsprechend dem Träger 4 aufweist, so dass über Schichtenbereiche 21, 21' und 21" die elektrische und thermische Verbindung zu den p- und n-seitigen Substratschichten 2, 3 hergestellt werden kann An die Schichtenbereiche 21', 21" sind nicht dargestellte elektrische Kontaktelemente geführt.

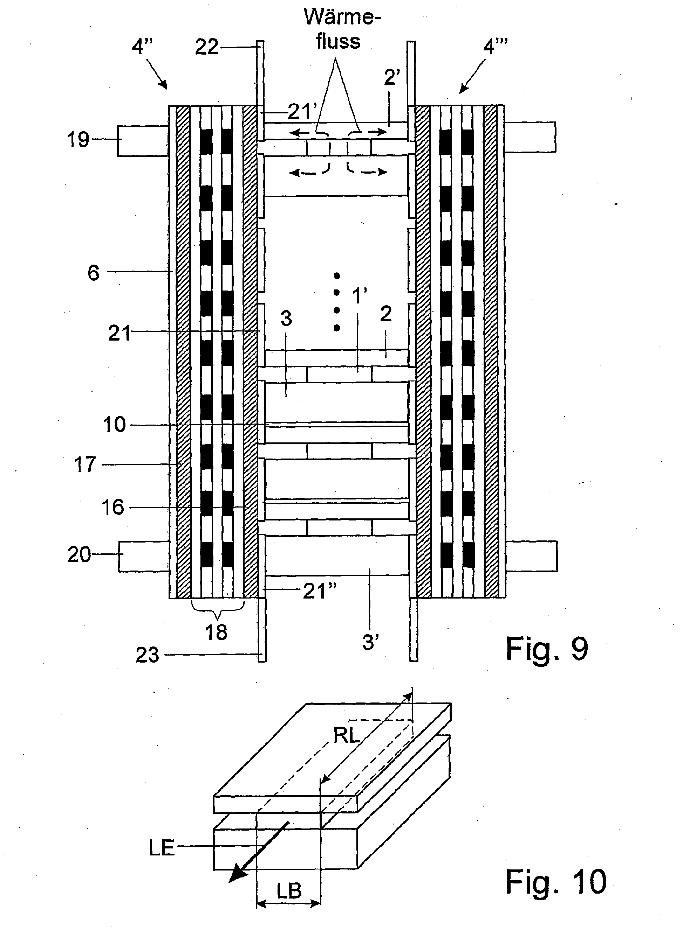

Die in Fig. 9 gezeigte Laserstrahlungsquelle enthalt als Laserdiodenelemente Halbleiterlaserdioden oder Laserdiodenbarren 1', die im Unterschied zu den Laserdiodenbarren 1 gemäß den Figuren 1 bis 6 und 8 ein anderes Verhältnis von Resonatorlänge RL zu Lichtemissionsflächenbreite LB (Ausdehnung in der parallel zur Ebene des p-n-Uberganges verlaufenden Slow-Axis-Richtung) aufweisen (Fig. 10). Ist die Resonatorlänge bereits größer als die halbe Lichtemissionsflächenbreite, so ist es vorteilhaft, eine Kühlung vorzunehmen, bei der die Wärme über die Substratschichten 2, 2', 3, 3' nicht entgegengesetzt zur Lichtemissionsrichtung LE der Laserdiodenelemente, sondern senkrecht dazu und senkrecht zur Stapelrichtung der Laserdiodenelemente abgefuhrt wird (gestrichelte Pfeilrichtungen). Der aus den Laserdiodenelementen gebildete Laserdiodenstapel ist zwischen zwei gleich aufgebauten mehrschichtigen Trägern 4", 4'" angeordnet, die z. B. mit einem Mikrokühler 18 entsprechend Fig. 7 ausgestattet sein können, wobei gegenpolige Substratschichten 2, 3 benachbarter Laserdiodenelemente auf gemeinsamen Schichtenbereichen (21) des jeweiligen mehrschichtigen Trägers 4", 4"' aufgebracht sind. Die übrigen verwendeten Bezugszeichen entsprechen in ihrer Bedeutung denen der vorhergehend beschriebenen Ausführungsbeispiele. Mit 22, 23 sind elektrische Kontaktelemente zur Stromzufuhr bezeichnet, die an die außen liegenden Schichtenbereiche 21', 21" geführt sind.
Die Befestigung der Substratschichten 2, 2', 3, 3' auf den Schichtenbereichen 21, 21', 21" erfolgt derart, dass die Lichtemissionsrichtung LE der Laserdiodenelemente parallel zu den Schichtenbereichen 21, 21', 21" gerichtet ist.

Laserdiodenelemente, wie sie gemäß der Ausführung nach Fig. 9 zur Anwendung kommen, bestehen z. B. aus 4 nebeneinander angeordneten Laserdioden. Das hat den Vorteil, dass im Unterschied zu breiteren Laserdiodenbarren, die sich üblicherweise aus 20 - 25 Laserdioden zusammensetzen können, keine Strahlaufteilung in umzuordnende Teilstrahlenbündel nötig ist.

Selbstverständlich ist es in einer weiteren Ausführung auch möglich, anstatt einer zweiseitigen Kühlung nur einen der mehrschichtigen Träger (4", 4'") vorzusehen.

## Patentansprüche

1. Laserstrahlungsquelle, enthaltend
- einen Stapel von Laserdiodenelementen (1, 1') und
- wenigstens einen ersten ebenen, mehrschichtigen plattenförmigen Träger (4, 4', 4"), bestehend aus einer ersten und wenigstens einer zweiten metallischen Schicht (5, 6), die durch mindestens eine elektrisch isolierende Schicht (7, 16, 17) aus nichtmetallischem Material getrennt sind, wobei
- wenigstens die erste metallische Schicht (5, 6) in nebeneinander und mit einem Abstand zueinander angeordnete metallische Schichtenbereiche (8, 8', 8", 9, 9', 9" ,21 , 21', 21 ") gegliedert ist, wobei
- jedes Laserdiodenelement beidseitig über p- und n-seitige Substratschichten (2, 2', 3, 3') aus elektrisch leitendem Material kontaktiert ist, **dadurch gekennzeichnet, dass**
- gegenpolige Substratschichten (2, 3) benachbarter Laserdiodenelemente (1, 1') auf gemeinsamen Schichtenbereichen (8, 21) der ersten metallischen Schicht (5) aufgebracht sind, so dass der Stromfluss bei der Serienschaltung benachbarter Laserdiodenelemente über die metallischen Schichtenbereiche (8, 21) des Trägers (4, 4', 4") geführt wird.

2. Laserstrahlungsquelle nach Anspruch 1, wobei zwischen den gegenpoligen Substratschichten (2, 3) benachbarter Laserdiodenelemente (1, 1') ein Spalt (10) freigelassen ist.

3. Laserstrahlungsquelle nach Anspruch 2, wobei die erste und die zweite metallische Schicht (5, 6) in nebeneinander und mit einem Abstand zueinander angeordnete metallische Schichtenbereiche (8, 8', 8", 9, 9', 9") gegliedert ist.

4. Laserstrahlungsquelle nach Anspruch 3, wobei die Schichtenbereiche (8, 8', 8") der ersten metallischen Schicht (5) und die Schichtenbereiche (9, 9', 9") der zweiten metallischen Schicht (6) deckungsgleich zueinander angeordnet sind.

5. Laserstrahlungsquelle nach Anspruch 3, wobei die Schichtenbereiche (8, 8', 8") der ersten metallischen Schicht (5) und die Schichtenbereiche (9, 9', 9") der zweiten metallischen Schicht (6) versetzt zueinander angeordnet sind

6. Laserstrahlungsquelle nach Anspruch 4 oder 5, wobei Substratschichten (2', 3'), die den Stapel aus Laserdiodenelementen (1, 1') begrenzen, jeweils allein auf einen Schichtenbereich (8', 8") aufgelötet sind und wobei an jeden Schichtenbereich (8', 8") ein elektrisches Kontaktelement zur Stromzufuhr geführt ist.

7. Laserstrahlungsquelle nach Anspruch 6, wobei die Schichtenbereiche (8', 8"), auf denen die Substratschichten (2', 3') aufgelötet sind, die den vertikalen Stapel aus Laserdiodenelementen (1, 1') begrenzen, im elektrischen Kontakt mit jeweils einem Schichtenbereich (9', 9") auf der gegenüberliegenden Seite des Trägers (4) stehen, auf der die elektrischen Kontaktelemente an den Schichtenbereichen (9', 9") angebracht sind

8. Laserstrahlungsquelle nach einem der Ansprüche 1 bis 7, wobei die Abmessungen der p-seitigen Substratschichten (2, 2') in Richtung senkrecht zu den Kontaktflächen des Laserdiodenelementes (1) das 0,5- bis 1-fache und die der n-seitigen Substratschichten (3) das 0,25- bis 0,5-fache der Resonatorlange der Laserdiodenelemente (1) betragen.

9. Laserstrahlungsquelle nach einem der Ansprüche 1 bis 8, wobei die Abmessungen der Substratschichten (2, 2', 3, 3') in Lichtemissionsrichtung über den Schichtenbereichen (8) die Resonatorlänge der Laserdiodenelemente (1) übersteigen, jedoch kleiner sind als das Doppelte der Resonatorlänge.

10. Laserstrahlungsquelle nach einem der Ansprüche 1 bis 9, wobei die Laserdiodenelemente (1) als Laserdiodenbarren ausgebildet sind

11. Laserstrahlungsquelle nach einem der Ansprüche 1 bis 7, wobei die Laserdiodenelemente (1') eine Resonatorlänge aufweisen, die größer ist als die halbe Ausdehnung der Lichtemissionsfläche in Slow-Axis-Richtung.

12. Laserstrahlungsquelle nach Anspruch 11, wobei die Substratschichten (2, 2', 3, 3') derart auf den Schichtenbereichen (21, 21', 21") befestigt sind, dass die Lichtemissionsrichtung (LE) der Laserdiodenelemente (1') parallel zu den Schichtenbereichen (21, 21', 21") gerichtet ist

13. Laserstrahlungsquelle nach Anspruch 12, wobei ein zweiter ebener, mehrschichtiger plattenförmiger Träger (4"'), bestehend aus einer ersten und einer zweiten metallischen Schicht, die durch mindestens eine elektrisch isolierende Schicht (16, 17) aus nichtmetallischem Material getrennt sind, vorgesehen ist, wobei wenigstens eine der metallischen Schichten in nebeneinander und mit einem Abstand zueinander angeordnete metallische Schichtenbereiche (21, 21', 21") gegliedert ist und der Stapel von Laserdiodenelementen (1') zwischen dem ersten mehrschichtigen Träger (4") und dem zweiten mehrschichtigen Träger (4"') angeordnet ist, und wobei gegenpolige Substratschichten (2, 3) benachbarter Laserdiodenelemente (1') auf gemeinsamen Schichtenbereichen (21) des jeweiligen Trägers (4", 4'") aufgebracht sind.

14. Laserstrahlungsquelle nach einem der Ansprüche 1 bis 13 **dadurch gekennzeichnet, dass** wenigstens ein Trager (4, 4', 4", 4"') wenigstens im Oberflächenbereich der Schichtenbereiche (8, 8', 8", 9, 9', 9", 21, 21', 21") einen thermischen Ausdehnungskoeffizienten aufweist, der dem der Substratschichten (2, 2', 3, 3') ähnlich ist.

15. Laserstrahlungsquelle nach Anspruch 14 **dadurch gekennzeichnet, dass** die Substratschichten (2, 2', 3, 3') über ein Gold-Zinn-Lot, das mehr als 50 Atomprozente Gold enthält, mit den Schichtenbereichen (8, 8', 8", 9, 9', 9", 21, 21', 21 ") verbunden sind.

16. Laserstrahlungsquelle nach einem der Ansprüche 1 bis 15, wobei die erste und die zweite metallische Schicht (5, 6) aus Kupfer besteht.

17. Laserstrahlungsquelle nach Anspruch 16, wobei die mindestens eine elektrisch isolierende Schicht (7, 16 ,17) aus einer Aluminiumnitrid-Keramik besteht.

18. Laserstrahlungsquelle nach Anspruch 17, wobei die Summe der Dicken der metallischen Schichten (5, 6) aus Kupfer doppelt so groß ist wie die Summe der Dicken der nichtmetallischen Schichten (7, 16, 17) aus Aluminiumnitrid-Keramik.

19. Laserstrahlungsquelle nach Anspruch 17, wobei die Summe der Dicken der metallischen Schichten (5, 6) aus Kupfer zu der Summe der Dicken der nichtmetallischen Schichten (7, 16 ,17) aus Aluminiumnitrid-Keramik Verhältnisse von 1,5:1 bis 2,0:1 bei Vickershärten des Kupfers von HV60 bis HV120 annimmt.

20. Laserstrahlungsquelle nach einem der Ansprüche 1 bis 19, wobei der mehrschichtige Träger (4', 4", 4"') mit einem zwischen nichtmetallischen Schichten (16, 17) angeordneten Mikrokühler (18) ausgestattet ist, der Kanäle für ein Kühlmedium aufweist, für das ein Zufuhrkanal (19) und ein Ableitungskanal (20) im Boden des mehrschichtigen Trägers (4') vorgesehen sind.

## Claims

1. Laser radiation source, comprising
- a stack of laser diode elements (1, 1') and
- at least one first planar, multilayered plate-shaped carrier (4, 4', 4"), consisting of a first and at least one second metallic layer (5, 6) separated by at least one electrically insulating layer (7, 16, 17) composed of non-metallic material, wherein
- at least the first metallic layer (5, 6) is subdivided into metallic layer regions (8, 8', 8", 9, 9', 9", 21, 21', 21") arranged alongside one another and at a distance from one another, wherein
- contact is made with each laser diode element on both sides via p-and n-side substrate layers (2, 2', 3, 3') composed of electrically conductive material,
**characterized in that**
- substrate layers (2, 3) of opposite polarities of adjacent laser diode elements (1, 1') are applied on common layer regions (8, 21) of the first metallic layer (5), such that the current flowing upon the series connection of adjacent laser diode elements is passed via the metallic layer regions (8, 21) of the carrier (4, 4', 4").

2. Laser radiation source according to Claim 1, wherein a gap (10) is left free between the substrate layers (2, 3) of opposite polarities of adjacent laser diode elements (1, 1').

3. Laser radiation source according to Claim 2, wherein the first and the second metallic layers (5, 6) are subdivided into metallic layer regions (8, 8', 8", 9, 9', 9") arranged alongside one another and at a distance from one another.

4. Laser radiation source according to Claim 3, wherein the layer regions (8, 8', 8") of the first metallic layer (5) and the layer regions (9, 9', 9") of the second metallic layer (6) are arranged congruently with respect to one another.

5. Laser radiation source according to Claim 3, wherein the layer regions (8, 8', 8") of the first metallic layer (5) and the layer regions (9, 9', 9") of the second metallic layer (6) are arranged in a manner offset with respect to one another.

6. Laser radiation source according to Claim 4 or 5, wherein substrate layers (2', 3') which delimit the stack of laser diode elements (1, 1') are soldered in each case solely onto a layer region (8', 8"), and wherein an electrical contact element for feeding current is led to each layer region (8', 8").

7. Laser radiation source according to Claim 6, wherein the layer regions (8', 8") on which the substrate layers (2', 3') which delimit the vertical stack of laser diode elements (1, 1') are soldered are in electrical contact with a respective layer region (9', 9") on the opposite side of the carrier (4), on which side the electrical contact elements are attached to the layer regions (9', 9").

8. Laser radiation source according to any of Claims 1 to 7, wherein the dimensions of the p-side substrate layers (2, 2') in a direction perpendicular to the contact areas of the laser diode element (1) are 0.5 to 1, and those of the n-side substrate layers (3) are 0.25 to 0.5, times the resonator length of the laser diode elements (1).

9. Laser radiation source according to any of Claims 1 to 8, wherein the dimensions of the substrate layers (2, 2', 3, 3') in the light emission direction above the layer regions (8) exceed the resonator length of the laser diode elements (1), but are smaller than double the resonator length.

10. Laser radiation source according to any of Claims 1 to 9, wherein the laser diode elements (1) are embodied as laser diode bars.

11. Laser radiation source according to any of Claims 1 to 7, wherein the laser diode elements (1') have a resonator length that is greater than half the extent of the light emission area in the slow-axis direction.

12. Laser radiation source according to Claim 11, wherein the substrate layers (2, 2', 3, 3') are fixed on the layer regions (21, 21', 21") in such a way that the light emission direction (LE) of the laser diode elements (1') is directed parallel to the layer regions (21, 21', 21").

13. Laser radiation source according to Claim 12, wherein provision is made of a second planar, multilayered plate-shaped carrier (4"'), consisting of a first and a second metallic layer separated by at least one electrically insulating layer (16, 17) composed of non-metallic material, wherein at least one of the metallic layers is subdivided into metallic layer regions (21, 21', 21") arranged alongside one another and at a distance from one another, and the stack of laser diode elements (1') is arranged between the first multilayered carrier (4") and the second multilayered carrier (4"'), and wherein substrate layers (2, 3) of opposite polarities of adjacent laser diode elements (1') are applied on common layer regions (21) of the respective carrier (4", 4"').

14. Laser radiation source according to any of Claims 1 to 13, **characterized in that** at least one carrier (4, 4', 4", 4"') at least in the surface region of the layer regions (8, 8', 8", 9, 9', 9", 21, 21', 21") has a coefficient of thermal expansion which is similar to that of the substrate layers (2, 2', 3, 3').

15. Laser radiation source according to Claim 14, **characterized in that** the substrate layers (2, 2', 3, 3') are connected to the layer regions (8, 8', 8", 9, 9', 9", 21, 21', 21") by means of a gold-tin solder containing more than 50 atom per cent of gold.

16. Laser radiation source according to any of Claims 1 to 15, wherein the first and the second metallic layers (5, 6) consist of copper.

17. Laser radiation source according to Claim 16, wherein the at least one electrically insulating layer (7, 16, 17) consists of an aluminium nitride ceramic.

18. Laser radiation source according to Claim 17, wherein the sum of the thicknesses of the metallic layers (5, 6) composed of copper is double the magnitude of the sum of the thicknesses of the non-metallic layers (7, 16, 17) composed of aluminium nitride ceramic.

19. Laser radiation source according to Claim 17, wherein the sum of the thicknesses of the metallic layers (5, 6) composed of copper with respect to the sum of the thicknesses of the non-metallic layers (7, 16, 17) composed of aluminium nitride ceramic assumes ratios of 1.5:1 to 2.0:1 given Vickers hardnesses of copper of HV60 to HV120.

20. Laser radiation source according to any of Claims 1 to 19, wherein the multilayered carrier (4', 4", 4"') is equipped with a microcooler (18) arranged between non-metallic layers (16, 17) and having channels for a cooling medium, for which a feed channel (19) and a discharge channel (20) are provided in the base of the multilayered carrier (4').

## Revendications

1. Source de rayonnement laser, comprenant
- une pile d'éléments à diode laser (1, 1') et
- au moins un premier support (4, 4', 4") plan multicouche en forme de plaque, composé d'une première et d'au moins une deuxième couche métallique (5, 6), lesquelles sont séparées par au moins une couche électriquement isolante (7, 16, 17) en un matériau non métallique,
- au moins la première couche métallique (5, 6) étant divisée en zones de couche métalliques (8, 8', 8", 9, 9', 9", 21, 21', 21") disposées les unes à côté des autres et espacées les unes des autres,
- chaque élément à diode laser étant en contact des deux côtés par le biais de couches de substrat côté p et n (2, 2', 3, 3') en matériau électriquement conducteur,
**caractérisée en ce que**
- les couches de substrat (2, 3) de polarités opposées des éléments à diode laser (1, 1') voisins sont appliquées sur des zones de couche (8, 21) communes de la première couche métallique (5), de sorte que le flux de courant, lors du branchement en série des éléments à diode laser voisins, passe par les zones de couche (8, 21) métalliques du support (4, 4', 4").

2. Source de rayonnement laser selon la revendication 1, avec laquelle un interstice (10) est laissé libre entre les couches de substrat (2, 3) de polarités opposées des éléments à diode laser (1, 1') voisins.

3. Source de rayonnement laser selon la revendication 2, avec laquelle les première et deuxième couches métalliques (5, 6) sont divisées en zones de couche métalliques (8, 8', 8", 9, 9', 9") disposées les unes à côté des autres et espacées les unes des autres.

4. Source de rayonnement laser selon la revendication 3, avec laquelle les zones de couche (8, 8', 8") de la première couche métallique (5) et les zones de couche (9, 9', 9") de la deuxième couche métallique (6) sont disposées en coïncidence les unes avec les autres.

5. Source de rayonnement laser selon la revendication 3, avec laquelle les zones de couche (8, 8', 8") de la première couche métallique (5) et les zones de couche (9, 9', 9") de la deuxième couche métallique (6) sont disposées décalées les unes des autres.

6. Source de rayonnement laser selon la revendication 4 ou 5, avec laquelle les couches de substrat (2', 3') qui délimitent la pile d'éléments à diode laser (1, 1') sont respectivement brasées seules sur une zone de couche (8', 8") et un élément de contact électrique destiné à l'arrivée de courant est amené sur chaque zone de couche (8', 8").

7. Source de rayonnement laser selon la revendication 6, avec laquelle les zones de couche (8', 8") sur lesquelles sont brasées les couches de substrat (2', 3') qui délimitent la pile verticale d'éléments à diode laser (1, 1') sont en contact électrique respectivement avec une zone de couche (9', 9") du côté opposé du support (4), sur lequel sont appliqués les éléments de contact électrique sur les zones de couche (9', 9").

8. Source de rayonnement laser selon l'une des revendications 1 à 7, avec laquelle les dimensions des couches de substrat (2, 2') côté p dans la direction perpendiculaire aux surfaces de contact de l'élément à diode laser (1) sont égales à 0,5 à 1 fois la longueur de résonateur des éléments à diode laser (1) et les couches de substrat (3) côté n à 0,25 à 0,5 fois.

9. Source de rayonnement laser selon l'une des revendications 1 à 8, avec laquelle les dimensions des couches de substrat (2, 2', 3, 3') dans le sens de l'émission de lumière au-dessus des zones de couche (8) sont supérieures à la longueur de résonateur des éléments à diode laser (1), mais toutefois inférieures au double de la longueur de résonateur.

10. Source de rayonnement laser selon l'une des revendications 1 à 9, avec laquelle les éléments à diode laser (1) sont réalisés sous la forme de barres de diodes laser.

11. Source de rayonnement laser selon l'une des revendications 1 à 7, avec laquelle les éléments à diode laser (1') présentent une longueur de résonateur qui est supérieure à la moitié de l'extension de la surface d'émission de lumière dans le sens de l'axe lent.

12. Source de rayonnement laser selon la revendication 11, avec laquelle les couches de substrat (2, 2', 3, 3') sont fixées sur les zones de couche (21, 21', 21") de telle sorte que le sens de l'émission de lumière (LE) des éléments à diode laser (1') est dirigé en parallèle des zones de couche (21, 21', 21 ").

13. Source de rayonnement laser selon la revendication 12, avec laquelle il est prévu un deuxième support (4"') plan multicouche en forme de plaque, composé d'une première et d'une deuxième couche métallique, lesquelles sont séparées par au moins une couche électriquement isolante (16, 17) en un matériau non métallique, au moins l'une des couches métalliques étant divisée en zones de couche métalliques (21, 21', 21") disposées les unes à côté des autres et espacées les unes des autres et la pile d'éléments à diode laser (1') étant disposée entre le premier support multicouche (4") et le deuxième support multicouche (4"'), et les couches de substrat (2, 3) de polarités opposées des éléments à diode laser (1') voisins étant appliquées sur des zones de couche (21) communes du support (4", 4"') correspondant.

14. Source de rayonnement laser selon l'une des revendications 1 à 13, **caractérisée en ce qu'**au moins un support (4, 4', 4", 4"') présente au moins dans la zone de surface des zones de couche (8, 8', 8", 9, 9', 9", 21, 21', 21") un coefficient de dilatation thermique qui est similaire à celui des couches de substrat (2, 2', 3, 3').

15. Source de rayonnement laser selon la revendication 14, **caractérisée en ce que** les couches de substrat (2, 2', 3, 3') sont reliées avec les zones de couche (8, 8', 8", 9, 9', 9", 21, 21', 21") par une brasure d'or-étain qui contient plus de 50 % atomiques d'or.

16. Source de rayonnement laser selon l'une des revendications 1 à 15, avec laquelle les première et deuxième couches métalliques (5, 6) se composent de cuivre.

17. Source de rayonnement laser selon la revendication 16, avec laquelle l'au moins une couche électriquement isolante (7, 16, 17) se compose d'une céramique nitrure d'aluminium.

18. Source de rayonnement laser selon la revendication 17, avec laquelle la somme des épaisseurs des couches métalliques (5, 6) en cuivre est égale au double de la somme des épaisseurs des couches non métalliques (7, 16, 17) en céramique nitrure d'aluminium.

19. Source de rayonnement laser selon la revendication 17, avec laquelle la somme des épaisseurs des couches métalliques (5, 6) en cuivre présente par rapport à la somme des épaisseurs des couches non métalliques (7, 16, 17) en céramique nitrure d'aluminium des rapports de 1,5:1 à 2,0:1 avec des duretés Vickers du cuivre de HV60 à HV120.

20. Source de rayonnement laser selon l'une des revendications 1 à 19, avec laquelle le support multicouche (4', 4", 4"') est équipé d'un microradiateur (18) disposé entre les couches non métalliques (16, 17), lequel présente des canaux pour un fluide réfrigérant pour lequel sont prévus un canal d'arrivée (19) et un canal d'évacuation (20) dans le fond du support multicouche (4').
